# EUROPEAN PATENT APPLICATION

(11) **EP 4 807 788 A1**
(43) Date of publication of application: **16.09.2026**
(21) Application number: 24902686.5
(22) Date of filing: 05.12.2024
(51) Int. Cl.: H01L 21/67, H01J 37/32

(54) **COVER DEVICE, PROCESS CHAMBER AND SEMICONDUCTOR PROCESS APPARATUS**

(30) Priority: 15.12.2023 CN 202311737419
(71) Applicant: Beijing NAURA Microelectronics Equipment Co., Ltd., Beijing 100176 (CN)
(72) Inventor: LIU, Dongxu, Beijing 100176 (CN); WANG, Guangyong, Beijing 100176 (CN)
(74) Representative: Cohausz & Florack
(86) International application number: PCT/CN2024/136985
(87) International publication number: WO 2025/124265

(57) **Abstract**

The present disclosure provides a cover device, a process chamber, and a semiconductor process apparatus. The provided cover device includes a cover, a connection base, and a cover base, a first end of the cover base is rotatably connected to the connection base, the cover base has a first state and a second state, and a second end of the cover base is rotatable around the first end of the cover base to switch the cover base between the first state and the second state; in the first state of the cover base, the cover is tilted relative to a preset plane, and the cover is movable relative to the cover base; and in the second state of the cover base, the cover is parallel to the preset plane. The solution can solve the problem of poor sealing of a process chamber in the related technology.

## Description

### TECHNICAL FIELD

The present disclosure belongs to the field of semiconductor technology, and particularly relates to a cover device, a process chamber, and a semiconductor process apparatus.

### BACKGROUND

A process chamber is an important component of a semiconductor process apparatus. The process chamber is used for implementation of semiconductor processes such as a cleaning process and a film deposition process. During a semiconductor process, sealing of the process chamber needs to be ensured to prevent a process space in the process chamber from communicating with an external environment of the process chamber. Process failure can be easily caused once the process space in the process chamber communicates with the external environment of the process chamber. In addition, gases for some processes (e.g., a cleaning process) are highly toxic gases, which can easily cause poisoning to operators once leaking into the external environment of the process chamber.

Therefore, design for the sealing of the process chamber is a top priority in structural design of the process chamber. However, the process chambers involved in the related technology are still faced with the problem of poor sealing.

### SUMMARY

The present disclosure provides a cover device, a process chamber, and a semiconductor process apparatus, so as to solve the problem of poor sealing of the process chamber in the related technology.

In order to solve the above technical problem, the present disclosure provides the following technical solutions.

In a first aspect, an embodiment of the present disclosure provides a cover device, including a cover, a connection base, and a cover base, a first end of the cover base is rotatably connected to the connection base, the cover base has a first state and a second state, and a second end of the cover base is rotatable around the first end of the cover base to switch the cover base between the first state and the second state; in the first state of the cover base, the cover is tilted relative to a preset plane, and the cover is movable relative to the cover base; and in the second state of the cover base, the cover is parallel to the preset plane.

In a second aspect, an embodiment of the present disclosure provides a process chamber, including a first seal ring, a chamber body, and the cover device described in the first aspect, the chamber body is provided with an opening, the first end of the cover base is far away from the opening, the second end of the cover base is close to the opening, and the preset plane is a plane where the opening is located;
in the first state of the cover base, the cover is tilted relative to the plane where the opening is located, and the cover is movable between a position for avoiding the opening and a position opposite to the opening; and
when the cover is located at the position opposite to the opening, the cover base is configured to be rotatable, while carrying the cover, to the second state in which the cover is parallel to the plane where the opening is located, so as to cause the cover to compress the first seal ring.

In a third aspect, an embodiment of the present disclosure provides a semiconductor process apparatus, including the process chamber described in the second aspect.

The technical solutions in the present disclosure can achieve the following technical effects.

In the cover device provided in the embodiment of the present disclosure, the cover can be carried by the cover base to rotate to change an inclination angle of the cover, and is movable in a state of being tilted relative to the preset plane, during which the cover can be tilted and move away from the first seal ring configured to seal the opening of the chamber body, or the cover can be tilted and move away from the chamber body while carrying the first seal ring configured to seal the opening of the chamber body. Thus, the cover can be prevented from wearing the first seal ring while moving, and wear of the first seal ring can be relieved, so that the first seal ring can seal the cover and the chamber body well. As can be seen, the cover device provided in the embodiment of the present disclosure is beneficial to improvement in sealing performance of the process chamber.

Meanwhile, during the switching, the first end of the cover base only rotates relative to the connection base, so that the first end of the cover base does not need to occupy a large space for movement, which facilitates further reduction of occupation of the space above the process chamber.

### BRIEF DESCRIPTION OF DRAWINGS

FIG. 1 is a schematic diagram of a process chamber in the related technology, with a cover in FIG. 1 not fully opened;
FIG. 2 is an exploded view of a partial structure of a process chamber according to an embodiment of the present disclosure in a case where a cover is in an open state;
FIG. 3 is a schematic diagram of a process chamber according to an embodiment of the present disclosure in a case where a cover is in an open state;
FIG. 4 is a top view of FIG. 3;
FIG. 5 is a right view of FIG. 2;
FIG. 6 is a schematic diagram of a process chamber according to another embodiment of the present disclosure;
FIG. 7 is a partial view of a chamber body according to an embodiment of the present disclosure;
FIG. 8 is a partial schematic structural diagram of a process chamber according to an embodiment of the present disclosure; substantially, FIG. 8 is a perspective view, with some contours indicated by dashed lines;
FIG. 9 is an exploded view illustrating mating of a lifting mechanism with a sealed chamber body according to an embodiment of the present disclosure;
FIG. 10 is a schematic diagram of the components of FIG. 9 after the components are assembled;
FIG. 11 is a top view of FIG. 10;
FIG. 12 is a right view of FIG. 10; and
FIG. 13 is a schematic structural diagram of a process chamber according to an embodiment of the present disclosure.

### Description of reference numerals:

001-chamber body, 002-cover, 003-drive device,
10-sealed chamber body, 11-chamber body, 111-surrounding plate, 12-cover, 13-first seal ring,
20-cleaning tank, 21-first on-off valve,
31-drying gas inlet pipe, 32-water film removal gas inlet pipe, 33-cleaning solution inlet pipe, 301-fifth on-off valve,
41-connection base, 42-cover base, 43-first drive mechanism, 44-rail, 45-second drive mechanism, 46-first limiting buffer portion, 47-second limiting buffer portion, 48-closure detection sensor, 49-closure detection trigger, 401-opening detection sensor, 402-opening detection trigger, 404-connecting piece, 405-movable frame, 406-hinge shaft,
50-lifting mechanism, 51-first base plate, 52-cap, 53-first connector, 54-telescopic sleeve, 55-third seal ring, 56-fourth seal ring, 57-fifth seal ring, 58-second base plate, 581-avoidance hole, 59-lifting rod, 501-second connector, 502-third connector, 503-leveling device,
60-pressing mechanism, 61-third drive mechanism, 62-pressing member, 601-first right-angle side, 602-second right-angle side, 63-fourth drive mechanism,
70-waste liquid discharge pipe, 71-main pipe, 72-first branch pipe, 73-second branch pipe, 74-third branch pipe, 75-second on-off valve, 76-third on-off valve, 77-drain buffer tank, 78-negative pressure suction pipe, 79-negative pressure pump, 701-fourth on-off valve, 702-adapter tube,
80-carrier,
90-wafer,
01-process space, 02-opening, 03-pipeline, 04-mounting hole, 05-sealing plate, 06-second seal ring, 07 -communicating hole, 08-sealing joint.

### DETAIL DESCRIPTION OF EMBODIMENTS

In order to make the objectives, technical solutions and advantages of the present disclosure clearer, the technical solutions of the present disclosure are clearly and thoroughly described below in conjunction with specific embodiments and the corresponding drawings. Apparently, the embodiments described herein are just some embodiments of the present disclosure, and do not cover all embodiments. All other embodiments derived by those of ordinary skill in the art from the embodiments described herein without any inventive work fall within the scope of the present disclosure.

The technical solutions provided in the embodiments of the present disclosure are described in detail below with reference to the drawings.

As described in the background part of the present disclosure, the design for the sealing of the process chamber is the top priority in the structural design of the process chamber. On this basis, the process chamber in the related technology includes a chamber body, a cover, and a first seal ring for sealing an opening in the chamber body; and the first seal ring may be fixed to the cover or fixedly disposed at an opening position of the chamber body. The cover is moved relative to the chamber body to switch between an open state and a closed state. However, It has been found during designing processes that while moving the cover to open or close the cover, there is significant friction between the cover and the first seal ring disposed at the opening position of the chamber body because the cover is moved close to the opening position of the chamber body, or significant friction is caused between the first seal ring and the opening of the chamber body during movement of the first seal ring carried by the cover, such that the first seal ring wears out quickly, resulting in failure to perform a sealing function well.

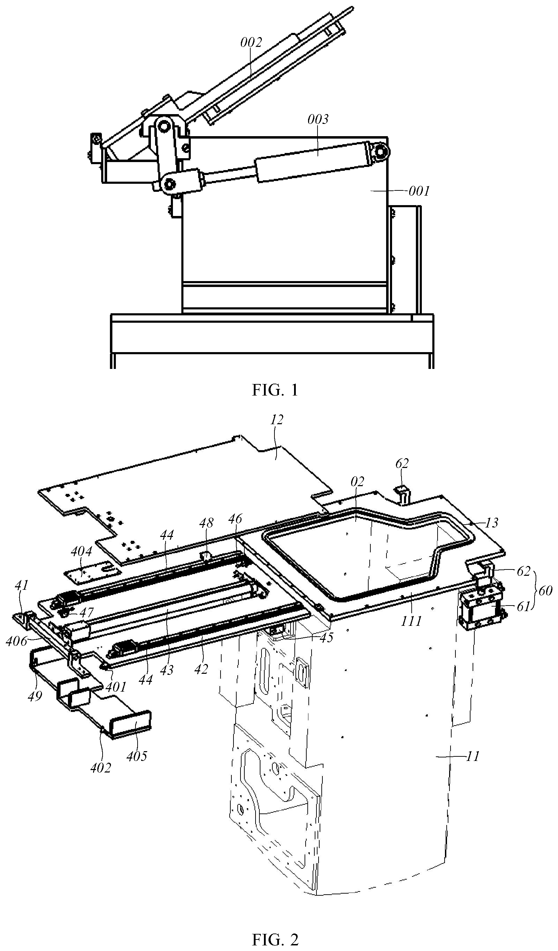

In view of the above, the structure of the process chamber is further improved. As shown in FIG. 1, the improved process chamber also includes a chamber body 001, a cover 002, and a first seal ring.

The chamber body 001 is a main peripheral member enclosing a process space in the process chamber, and is provided with an opening communicating with an inner space of the chamber body 001. The cover 002 is rotatably disposed on the chamber body 001 to switch between an open state and a closed state by rotation relative to the chamber body 001.

In the open state, the cover 002 is rotated to a position at which the cover 002 exposes the opening and is staggered relative to the opening, the inner space of the chamber body 001 communicates with an external environment of the process chamber, and an operator can perform corresponding operations, such as maintenance operations and fetching/placing wafers.

In the closed state, the cover 002 is rotated to a position at which the cover 002 covers the opening and may press the first seal ring firmly, so that the first seal ring is pressed firmly between the cover 002 and the chamber body 001, thereby achieving sealing between the cover 002 and the chamber body 001. In this case, the cover 002, the first seal ring, and the chamber body 001 enclose the process space. The first seal ring facilitates hematic isolation between the process space and the external environment of the process chamber.

The process chamber shown in FIG. 1 may further include a drive mechanism 003, which is connected to the cover 002 and the chamber body 001, and is configured to drive the cover 002 to rotate relative to the chamber body 001. During the designing of the structure of the process chamber, it has further been found that the cover 002 of the process chamber with such structure does not rub the first seal ring or cause the first seal ring to rub the chamber body 001 during the rotation of the cover 002, but the cover 002 needs to be rotated by a large angle to be fully opened (FIG. 1 just illustrates an opening process of the cover 002, and the cover 002 in FIG. 1 is not in the open state in which the cover 002 is fully opened). Therefore, a relatively large space above the process chamber needs to be reserved for the rotation of the cover 002, which substantially leads to occupation of a relatively large space above the process chamber. Since the space above the process chamber is generally for deployment of a transfer device (e.g., a manipulator) configured to carry wafers, the transfer device cannot be compactly disposed above the process chamber if the process chamber occupies the relatively large space above the process chamber.

On this basis, the structure of the process chamber is improved again to solve the above problems. Referring to FIG. 2 to FIG. 4, an embodiment of the present disclosure provides a cover device. The provided cover device may be applied to a process chamber as part of the process chamber. The provided cover device can adjust a posture of a cover to avoid wear of a first seal ring caused while opening or closing the cover.

The cover device provided in the embodiment of the present disclosure may include a cover 12, a connection base 41, and a cover base 42. The cover 12 is movably disposed on the cover base 42 to move relative to the cover base 42. The cover base 42 not only provides a mounting base for the cover 12, but also can carry the cover 12 to rotate through rotation of the cover base 42 to adjust a posture of the cover 12. In an embodiment, a first end of the cover base 42 is rotatably connected to the connection base 41, the cover base 42 has a first state and a second state, and a second end of the cover base 42 is capable of rotating around the first end of the cover base 42, thereby switching the cover base 42 between the first state and the second state.

In the first state of the cover base 42, the cover 12 is tilted relative to a preset plane. In the embodiment of the present disclosure, the preset plane may be a plane parallel to a plane where an opening 02 of the chamber body 11 is located, or may be the plane where the opening 02 is located, or may be a plane substantially parallel to the plane where the opening 02 of the chamber body 11 is located. Certainly, with the cover 12 tilted relative to the preset plane in the first state of the cover base 42, the cover 12 is prevented from wearing a first seal ring 13 while moving.

In the second state of the cover base 42, the cover 12 is parallel to the preset plane. In the second state, when the cover 12 is located at a position opposite to the opening 02 of the chamber body 11, the cover 12 may compress and press the first seal ring 13 firmly, thereby sealing the opening 02 of the chamber body 11. That is, through the rotation of the second end of the cover base 42 around the first end of the cover base 42, the cover base 42 can carry the cover 12 disposed thereon to switch the cover 12 between being tilted relative to the preset plane and being parallel to the preset plane.

As described above, the process chamber involved in the embodiment of the present disclosure involves the first seal ring, and in some embodiments, the first seal ring 13 may be fixedly connected to the cover 12 and move relative to the chamber body 11 together with the cover 12. When the cover 12 is tilted relative to the preset plane, the cover 12 carries the first seal ring 13 to tilt together with the cover 12, so that the first seal ring 13 is kept away from the chamber body 11, and no friction is caused between the first seal ring 13 and the chamber body 11 during the movement of the cover 12. In some other embodiments, the first seal ring 13 may be fixedly connected to the chamber body 11 and disposed around the opening 02, and does not move together with the cover 12. In this case, when the cover 12 is tilted relative to the preset plane, the cover 12 is tilted relative to the first seal ring 13 and the chamber body 11 to be kept away from the first seal ring 13, so that the cover 12 does not rub against the first seal ring 13 while moving, thereby avoiding wearing the first seal ring 13.

In the cover device provided in the embodiment of the present disclosure, the cover 12 can be carried by the cover base 42 to rotate to change an inclination angle of the cover 12, and is movable in a state of being tilted relative to the preset plane, during which the cover 12 can be tilted and move away from the first seal ring 13 configured to seal the opening 02 of the chamber body 11, or the cover 12 can be tilted and move away from the chamber body 11 while carrying the first seal ring 13, which is disposed on the cover 12 for sealing the opening 02 of the chamber body 11. Thus, the cover 12 can be prevented from wearing the first seal ring 13 while moving, and the wear of the first seal ring 13 can be relieved, so that the first seal ring 13 can seal the cover 12 and the chamber body 11 well. As can be seen, the cover device provided in the embodiment of the present disclosure is beneficial to improvement in sealing performance of the process chamber.

In order to improve the degree of automation of the cover device, in some embodiments, the cover device provided in the embodiment of the present disclosure may further include a first drive mechanism 43, which is disposed on the cover base 42 and connected to the cover 12. The first drive mechanism 43 is configured to drive the cover 12 to move when the cover base 42 is in the first state. The first drive mechanism 43 may be a linear motor, a telescopic cylinder, a telescopic hydraulic cylinder, or the like, and a specific type of the first drive mechanism 43 is not limited in the embodiments of the present disclosure. In an embodiment, as shown in FIG. 2, the first drive mechanism 43 may be connected to the cover 12 through a connecting piece 404. During a driving process, the first drive mechanism 43 may drive the connecting piece 404 to move, and movement of the connecting piece 404 may drive the cover 12 to move, thereby driving the movement of the cover 12.

In some embodiments, the cover base 42 may be further provided with a guide part. Illustratively, the guide part is a rail 44, which has one end located close to the first end of the cover base 42 and the other end located close to the second end of the cover base 42; and the cover 12 may be in guiding engagement with the rail 44, so that the cover 12 is guided to move when the cover base 42 is in the first state. The rail 44 has a guiding function and thus can guide the cover 12 to move in a more regulated manner, thereby improving movement accuracy of the cover 12.

In some embodiments, one rail 44 may be provided; and in some other embodiments, at least two rails 44 may be provided. In a case where at least two rails 44 are provided, the at least two rails 44 are spaced apart on the cover base 42 and are respectively in guiding engagement with the cover 12. In this case, the at least two rails 44 can both guide the cover 12, thereby further improving the movement accuracy of the cover 12.

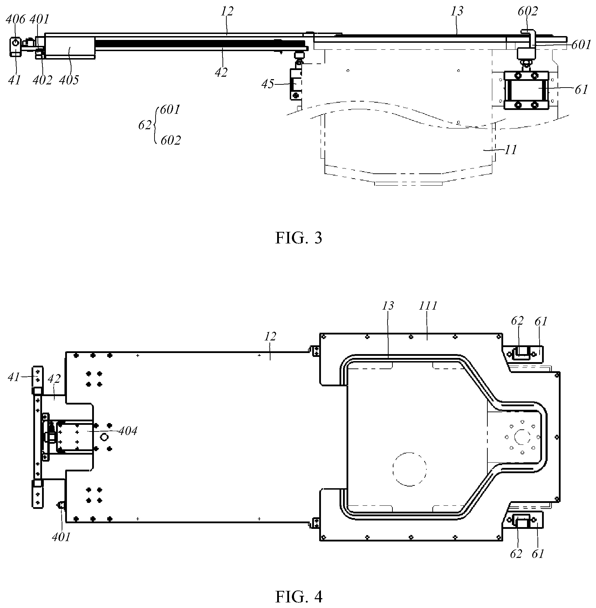

In some embodiments of the present disclosure, the rotation of the cover base 42 relative to the connection base 41 may be driven manually. Certainly, in order to improve the degree of automation of the process chamber, in the embodiments illustrated by FIG. 2 and FIG. 3, the cover device provided in the embodiment of the present disclosure may further include a second drive mechanism 45. The second drive mechanism 45 may be fixedly connected to an outer wall of the chamber body 11. Certainly, the second drive mechanism 45 may be fixedly connected to other mounting bases, which is not limited in the embodiments of the present disclosure. In an embodiment, the second drive mechanism 45 is connected to the second end of the cover base 42, and is configured to drive the second end of the cover base 42 to rotate around the first end of the cover base 42, so as to switch the cover base 42 between the first state and the second state. Illustratively, the second drive mechanism 45 may be a linear motor, a telescopic cylinder, a telescopic hydraulic cylinder, or the like, and a specific type of the second drive mechanism 45 is not limited in the embodiments of the present disclosure. In an embodiment, the second drive mechanism 45 may be rotatably connected to the second end of the cover base 42, so as to adapt to the rotation of the cover base 42.

As described above, in an operation process, the cover 12 is moved relative to the cover base 42, and the cover 12 has a first preset position and a second preset position relative to the cover base 42; when the cover 12 is moved to the first preset position, the cover 12 is far away from the first end of the cover base 42; when the cover 12 is moved to the second preset position, the cover 12 is close to the first end of the cover base 42. In order to avoid excessive movement of the cover 12, in an embodiment, the second end of the cover base 42 may be provided with a first limiting part. When the cover 12 is moved to the first preset position, the cover 12 may be in limiting contact with the first limiting part, so as to be prevented from moving excessively along the cover base 42. It should be noted that the cover 12 is moved to the position opposite to the opening 02 when the cover 12 is moved to the first preset position. At this time, a distance from the cover 12 to a rotational connection portion of the cover base 42 is a first distance.

In an embodiment, the first limiting part may be a first limiting buffer portion 46, and the first limiting buffer portion 46 is an elastic structural member (such as a rubber block or a spring) and has a buffer function, so that the first limiting buffer portion 46 not only performs a limiting function but also performs a buffer function in limiting contact with the cover 12, thereby avoiding rigid collision.

In some other embodiments, the first end of the cover base 42 may be provided with a second limiting part. When the cover 12 is moved to the second preset position, the cover 12 may be in limiting contact with the second limiting part, so as to be prevented from moving excessively along the cover base 42. It should be noted that the cover 12 is located at a position for avoiding the opening 02 when the cover 12 is moved to the second preset position. At this time, a distance from the cover 12 to the rotational connection portion of the cover base 42 is a second distance, and the first distance is greater than the second distance. It should be noted that since the first end of the cover base 42 is rotatably connected to the connection base 41, the distance from the cover 12 to the rotational connection portion of the cover base 42 is equivalent to a distance from the cover 12 to the first end of the cover base 42. When the cover 12 is moved to the first preset position, the cover 12 is located at the position opposite to the opening 02, that is, the cover 12 is far away from the first end of the cover base 42, so that the corresponding first distance is greater; when the cover 12 is moved to the second preset position, the cover 12 is located at the position for avoiding the opening 02, that is, the cover 12 is close to the first end of the cover base 42, so that the corresponding second distance is smaller.

It should be noted that the first limiting part and the second limiting part have opposite limiting directions. Similarly, in an embodiment, the second limiting part may be a second limiting buffer portion 47, and the second limiting buffer portion 47 is an elastic structural member (such as a rubber block or a spring) and has a buffer function, so that the second limiting buffer portion 47 may also perform a buffer function in limiting contact with the cover 12, thereby avoiding rigid collision.

The second end of the cover base 42 may be provided with a closure detection sensor 48, and the cover 12 may be provided with a closure detection trigger 49. When the cover 12 is moved to the first preset position, the closure detection trigger 49 triggers the closure detection sensor 48 to enable the closure detection sensor 48 to send a signal indicating that the cover 12 is closed. The first drive mechanism 43 may be turned off after receiving the signal.

The first end of the cover base 42 may be provided with an opening detection sensor 401, and the cover 12 may be provided with an opening detection trigger 402. When the cover 12 is moved to the second preset position, the opening detection trigger 402 triggers the opening detection sensor 401 to enable the opening detection sensor 401 to send a signal indicating that the cover 12 is open. The first drive mechanism 43 may be turned off after receiving the signal.

In an embodiment, the closure detection trigger 49 and the opening detection trigger 402 may be directly mounted on the cover 12 and move together with the cover 12. Certainly, the closure detection trigger 49 and the opening detection trigger 402 may be indirectly mounted on the cover 12. Further, for convenience of installation, the cover device provided in the embodiment of the present disclosure may further include a movable frame 405. As shown in FIG. 2, the closure detection trigger 49 and the opening detection trigger 402 may be mounted on the movable frame 405, and the movable frame 405 is connected to the cover 12 and may move together with the cover 12. That is, the movable frame 405 may achieve indirect mounting of the closure detection trigger 49 and the opening detection trigger 402 on the cover 12. During the movement of the cover 12, the movable frame 405 can carry the closure detection trigger 49 and the opening detection trigger 402 to different positions to perform different trigger functions.

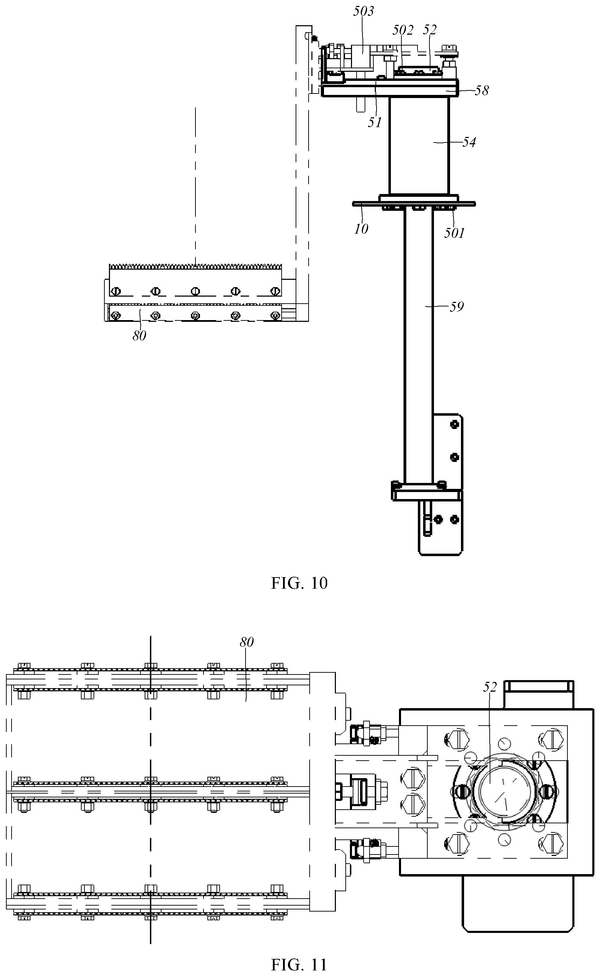

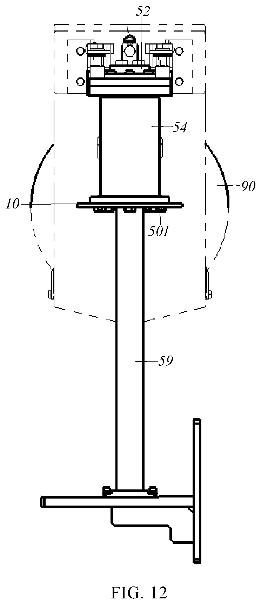

Referring to FIG. 2 to FIG. 13, an embodiment of the present disclosure provides a process chamber. The provided process chamber includes: a chamber body 11, a cover 12, and a first seal ring 13. Further, the process chamber provided in the embodiment of the present disclosure may further include: a connection base 41 and a cover base 42, that is, the process chamber provided in the embodiment of the present disclosure includes the cover device described in the above embodiments.

In an embodiment, a first end of the cover base 42 away from an opening 02 is rotatably connected to the connection base 41. The cover base 42 has a first state and a second state, and a second end of the cover base 42 close to the opening 02 is rotatable around the first end of the cover base 42, so as to switch the cover base 42 between the first state and the second state. The second end of the cover base 42 is between the first end of the cover base 42 and the opening 02 of the chamber body 11.

In the first state of the cover base 42, the cover 12 is tilted relative to a plane where the opening 02 is located (for example, the cover 12 is tilted relative to the plane by 0.7° to 0.8°). In the second state of the cover base 42, the cover 12 is parallel to the plane where the opening 02 is located. In essence, the cover base 42 can change an angle between the cover 12 and the plane where the opening 02 is located by rotation.

In the first state of the cover base 42, the cover 12 is tilted relative to the plane where the opening 02 is located, and the cover 12 is movable between a position for avoiding the opening 02 and a position opposite to the opening 02. It should be noted that when the cover 12 is located at the position opposite to the opening 02, the cover 12 is directly above the opening 02, and an orthographic projection of the cover 12 on the opening 02 may cover the opening 02.

When the cover 12 is located at the position opposite to the opening 02, the cover base 42 may be rotated to the first state to prepare for moving the cover 12 into an open state. Or, the cover base 42 carrying the cover 12 may be rotated to the second state in which the cover 12 is parallel to the plane where the opening 02 is located, so as to cause the cover 12 to press the first seal ring 13 firmly, so that the first seal ring 13 is sandwiched firmly between the cover 12 and the chamber body 11, and the cover 12 is finally in a closed state. That is, when the cover base 42 carrying the cover 12 is rotated to the second state, the cover base 42 may cause the cover 12 to compress and press the first seal ring 13 firmly.

In an embodiment, in a process of switching the cover 12 from the open state to the closed state, the cover base 42 is rotated into the first state, at this time, the cover 12 carried by the cover base 42 is in the state of being tilted relative to the plane where the opening 02 is located (for example, the cover 12 is tilted relative to the plane where the opening 02 is located by 0.7° to 0.8°). Then, the cover 12 is moved relative to the cover base 42 to the position opposite to the opening 02 to be above the opening 02. Then, the cover base 42 is rotated into the second state to cause the cover 12 to rotate to a position at which the cover 12 is parallel to the plane where the opening 02 is located and press the first seal ring 13 firmly. Under the action of the cover 12, the first seal ring 13 is sandwiched firmly between the cover 12 and the chamber body 11, thereby achieving sealing between the cover 12 and the chamber body 11. During this process, the cover 12 in the tilted state does not rub against the first seal ring 13 while moving, or the cover 12 in the tilted state does not cause friction between the first seal ring 13 and the chamber body 11 while moving.

In a process of switching the cover 12 from the closed state to the open state, the cover base 42 is rotated to switch from the second state (at this time, the cover 12 is in the closed state, that is, the cover 12 hermetically presses the first seal ring 13 to hermetically connect the first seal ring 13 to the cover 12 and the chamber body 11) to the first state, so that the cover 12 is separated from the first seal ring 13, or the cover 12 carrying the first seal ring 13 is separated from the chamber body 11. Then, the cover 12 is moved relative to the cover base 42 to a position offset from the opening 02, so as to be in the open state. During this process, the cover 12 is tilted to separate from the first seal ring 13, or the cover 12 carrying the first seal ring 13 is tilted to separate from the chamber body 11, so that the cover 12 does not rub against the first seal ring 13 while moving or the cover 12 does not cause the friction between the first seal ring 13 and the chamber body 11 while moving.

As can be seen from the above description of the operation process, in the process chamber provided in the embodiment of the present disclosure, the cover 12 is movably disposed on the rotatable cover base 42, and the cover base 42 in the first state can guide the cover 12 to move obliquely relative to the plane where the opening 02 is located and move between the position for avoiding the opening 02 and the position opposite to the opening 02, so that the cover 12 is prevented from wearing the first seal ring 13 while being opened or closed, thereby avoiding the problem of poor sealing caused by wear of the first seal ring 13. Meanwhile, in the process chamber provided in the embodiment of the present disclosure, during the switching of the cover 12 between the open state and the closed state, the cover base 42 carrying the cover 12 just needs to be rotated to an inclined position at which the cover 12 can be separated from the first seal ring 13 or the cover 12 carrying the first seal ring 13 can be separated from the chamber body 11, and the cover base 42 carrying the cover 12 does not need to be rotated by a large angle, which can reduce the occupation of the space above the process chamber.

Meanwhile, during the switching, the first end of the cover base 42 only rotates relative to the connection base 41, so that the first end of the cover base 42 does not need to occupy a large space for movement, which facilitates further reduction of the occupation of the space above the process chamber.

As described above, the first seal ring 13 may be fixed to the cover 12 to move relative to the chamber body 11 together with the cover 12. Or, the first seal ring 13 may be fixed to the chamber body 11, and the cover 12 is moved relative to the chamber body 11 and the first seal ring 13. Whether the first seal ring 13 is mounted on the cover 12 or the chamber body 11 is not limited in the embodiments of the present disclosure as long as it can be ensured that the first seal ring 13 is pressed firmly by the cover 12 to seal the cover 12 and the chamber body 11 when the cover 12 is closed.

In a case where the first seal ring 13 is disposed on the chamber body 11, in order to facilitate arrangement of the first seal ring 13, the chamber body 11 may include a surrounding plate 111 around the opening 02, and the surrounding plate 111 has relatively large area to facilitate the arrangement of the first seal ring 13. In an embodiment, the surrounding plate 111 may be provided with an annular groove around the opening 02, and the first seal ring 13 may be fixed in the annular groove, so as to be mounted stably.

In the embodiments of the present disclosure, rotational connection of the cover base 42 and the connection base 41 may be implemented through various structures. For example, the first end of the cover base 42 may be rotatably connected to the connection base 41 by means of a shaft hinge. As shown in FIG. 2, a hinge shaft 406 may be mounted to the connection base 41, and the first end of the cover base 42 may be rotatably connected to the connection base 41 through the hinge shaft 406. For example, the first end of the cover base 42 may be rotatably mounted to the connection base 41 through a flexible member or an elastic member. A specific rotational connection manner of the first end of the cover base 42 and the connection base 41 is not limited in the embodiments of the present disclosure.

In a case where the cover device includes rails 44, all rails 44 and the cover base 42 may be located on the side of a same edge of the opening 02, as shown in FIG. 2. Such arrangement can prevent the rails 44 from occupying the side of another edge of the opening 02, so that the process chamber just needs to occupy small space in other directions.

In some embodiments, in a case where the cover device includes a first limiting part, the cover 12 may be in limiting contact with the first limiting part when the cover 12 is moved to the position opposite to the opening 02 (i.e. the first preset position), so as to be prevented from moving excessively along the cover base 42.

In some other embodiments, in a case where the cover device includes a second limiting part, the cover 12 may be in limiting contact with the second limiting part when the cover 12 is moved to the position for avoiding the opening 02 (i.e., the second preset position).

In a case where the second end of the cover base 42 is provided with a closure detection sensor 48 and the cover 12 is provided with a closure detection trigger 49, the closure detection trigger 49 triggers the closure detection sensor 48 when the cover 12 is moved to the position opposite to the opening 02.

In a case where the first end of the cover base 42 is provided with an opening detection sensor 401 and the cover 12 is provided with an opening detection trigger 402, the opening detection trigger 402 triggers the opening detection sensor 401 when the cover 12 is moved to the position offset from the opening 02.

As described above, in a case where the cover base 42 is rotated into the second state, the cover 12 can press the first seal ring 13 firmly, so that the first seal ring 13 can achieve the sealing between the cover 12 and the chamber body 11. In order to improve sealing effect, the process chamber provided in the embodiment of the present disclosure may further include a pressing mechanism 60, which may be fixed to an outer wall of the chamber body 11. When the cover 12 is located at a position at which the cover 12 is opposite to the opening 02 and parallel to the plane where the opening 02 is located, the pressing mechanism 60 is configured to apply a pressure to the cover 12 for the cover 12 to compress the first seal ring 13, so that the cover 12 may press the first seal ring 13 more firmly, and the first seal ring 13 may be pressed well to perform a sealing function.

In some embodiments of the present disclosure, one pressing mechanism 60 may be provided; and in some other embodiments, at least two pressing mechanisms 60 may be provided. A specific type of the pressing mechanism 60 is not limited in the embodiments of the present disclosure. In a case where at least two pressing mechanisms 60 are provided, the pressing mechanisms 60 may be spaced apart on the outer wall of the chamber body 11.

The pressing mechanism 60 may be of various types. For example, the pressing mechanism 60 may be a clamping mechanism. Any mechanism capable of driving the cover 12 to press the first seal ring 13 firmly against the chamber body 11 may be used as the pressing mechanism 60 in the embodiments of the present disclosure. Referring to FIG. 2 to FIG. 5, in the embodiments of the present disclosure, the pressing mechanism 60 may include: a third drive mechanism 61 and a pressing member 62. The third drive mechanism 61 may be fixedly connected to the outer wall of the chamber body 11, the pressing member 62 is connected to an extendable end of the third drive mechanism 61 to realize driving engagement, and the third drive mechanism 61 is configured to drive the pressing member 62 to switch between a releasing state and a pressing state. In the pressing state, a partial structure of the pressing member 62 abuts against a side of the cover 12 away from the chamber body 11, and presses the cover 12 towards the chamber body 11 to compress the first seal ring 13. In the releasing state, the pressing member 62 is separated from at least the cover 12 to provide conditions for the movement of the cover 12, at this time, the pressing member 62 no longer abuts against the cover 12.

In an embodiment, when the cover 12 is moved to a position for covering the opening 02, an edge of the cover 12 is located between the partial structure of the pressing member 62 which is configured to abut against the cover 12 and the chamber body 11. Since the cover 12 is movable relative to the chamber body 11, the partial structure of the pressing member 62 which is configured to abut against the cover 12 is located above the cover 12, the chamber body 11 is located below the cover 12, and the pressing member 62 may be pulled under the driving of the third drive mechanism 61, so that the pressing member 62 may press the cover 12 firmly against the chamber body 11. Certainly, when the third drive mechanism 61 pushes the pressing member 62 upwards, the structure of the pressing member 62 which is above the cover 12 may be separated from the cover 12, so as to release the cover 12.

The pressing member 62 may be of various structures. In some embodiments, the pressing member 62 may be an L-shaped structural member, and includes a first right-angle side 601 and a second right-angle side 602 perpendicularly connected to each other, and the first right-angle side 601 is connected to the extendable end of the third drive mechanism 61 to realize driving connection. When the cover 12 is moved to the position for covering the opening 02, the edge of the cover 12 is located between the second right-angle side 602 and the chamber body 11. Certainly, the structure of the pressing member 62 may be changed by adjusting an included angle between the first right-angle side 601 and the second right-angle side 602, which may also achieve the purpose of pressing. The specific structure of the pressing member 62 is not limited in the embodiments of the present disclosure. With the above structure, the pressing member 62 can be switched between the releasing state and the pressing state only through telescopic movement of the third drive mechanism 61, which is simple both in structure and in operation.

In a case where the pressing member 62 is the L-shaped structural member, the first right-angle side 601 and the second right-angle side 602 may be an integral structure (i.e., manufactured by one-piece processing), or may be split structures which are assembled and connected by welding or through connecting members, which is not limited in the embodiments of the present disclosure.

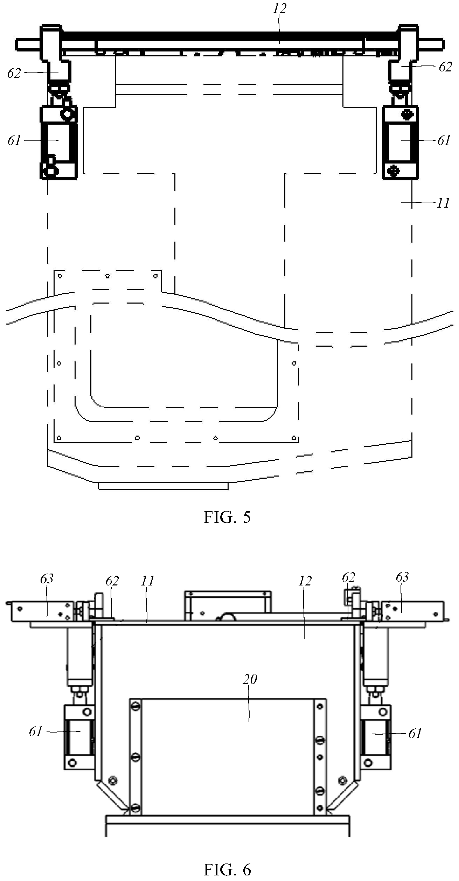

In some other embodiments, referring to FIG. 6, the pressing mechanism 60 may further include: a fourth drive mechanism 63, and the fourth drive mechanism 63 may be fixed to the extendable end of the third drive mechanism 61, so that the third drive mechanism 61 may drive the fourth drive mechanism 63 to move through the extendable end. The pressing member 62 is disposed at an extendable end of the fourth drive mechanism 63, and the fourth drive mechanism 63 is configured to drive the pressing member 62 to switch between a first position and a second position. When the pressing member 62 is at the first position, the pressing member 62 is located on a side of the cover 12 away from the chamber body 11, and the third drive mechanism 61 may drive the pressing member 62 through the fourth drive mechanism 63 to switch between the pressing state and the releasing state. In the pressing state, the cover 12 may press the first seal ring 13 firmly; and in the releasing state, the cover 12 may release the first seal ring 13.

When the pressing member 62 is at the second position, the pressing member 62 is staggered relative to the cover 12, that is, the pressing member 62 avoids the side of the cover 12 away from the chamber body 11, in which case the pressing member 62 does not interfere with the rotation of the cover 12 along with the cover base 42 or the movement of the cover 12.

It should be noted that a moving direction of the extendable end of the third drive mechanism 61 may be different from that of the extendable end of the fourth drive mechanism 63, that is, a moving direction in which the pressing member 62 is driven to move by the extendable end of the third drive mechanism 61 through the fourth drive mechanism 63 is different from a moving direction in which the pressing member 62 is driven to move by the extendable end of the fourth drive mechanism 63. For example, the moving direction of the extendable end of the third drive mechanism 61 may be perpendicular to that of the extendable end of the fourth drive mechanism 63.

Since the fourth drive mechanism 63 may drive the pressing member 62 to switch between the first position and the second position, no more limitations need to be imposed on the structure of the pressing member 62. For example, the pressing member 62 may be a flat structural member, or may be other structural members.

The third drive mechanism 61 and the fourth drive mechanism 63 may be the same or different in type and structure, which is not limited in the embodiments of the present disclosure. The third drive mechanism 61 and the fourth drive mechanism 63 may be hydraulic telescopic members, pneumatic telescopic members, linear motors, or the like, and specific types of the third drive mechanism 61 and the fourth drive mechanism 63 are not limited in the embodiments of the present disclosure.

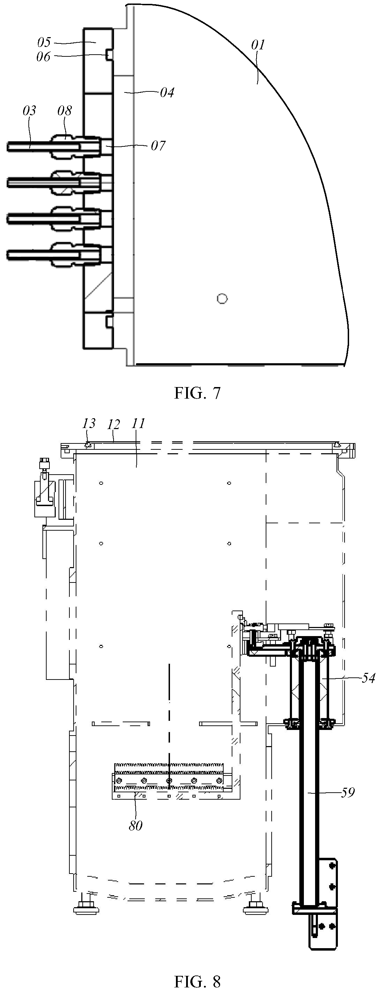

Process gases such as a deposition gas and a drying gas need to be introduced into the process space 01 during semiconductor processes. In order to ensure good hermetic isolation between the process space 01 and the external environment of the process chamber, referring to FIG. 7, in an embodiment, the process chamber provided in the embodiment of the present disclosure may further include: a pipeline 03, a sealing plate 05, a second seal ring 06, and a sealing joint 08, the chamber body 11 may be provided with a mounting hole 04, the sealing plate 05 is detachably fixed to the mounting hole 04 in the chamber body 11, the mounting hole 04 is sealed with the second seal ring 06, the sealing plate 05 is provided with a communicating hole 07, and the pipeline 03 may be detachably connected to the communicating hole 07 with the sealing joint 08, so as to communicate with the inner space of the chamber body 11.

Further, one pipeline 03 may be provided, or at least two pipelines 03 may be provided, the sealing plate 05 may be provided with at least two communicating holes 07 in one-to-one correspondence with the pipelines 03, and the pipelines 03 are respectively hermetically connected to the corresponding communicating holes 07 through corresponding sealing joints 08. The pipelines 03 may have the same function or have different functions, which is not limited in the embodiments of the present disclosure.

It should be noted that the pipelines 03 in the embodiment of the present disclosure may include a drying gas inlet pipe 31, a water film removal gas inlet pipe 32, a cleaning solution inlet pipe 33, and a waste liquid discharge pipe 70, which are described later. Certainly, the pipelines 03 in the embodiment of the present disclosure may include other functional pipelines disposed in the process chamber, which is not limited in the embodiments of the present disclosure.

A specific type of the process chamber is not limited in the embodiments of the present disclosure, and the process chamber may be a chemical vapor deposition process chamber, an atomic layer deposition process chamber, or the like. Certainly, the process chamber may be a cleaning chamber used for a cleaning process to clean a wafer 90.

In a case where the process chamber provided in the embodiment of the present disclosure is a cleaning chamber, referring to FIG. 8 to FIG. 13, the process chamber provided in the embodiment of the present disclosure includes a sealed chamber body 10, a cleaning tank 20, a lifting mechanism 50, and a carrier 80 for carrying the wafer 90, and the sealed chamber body 10 includes the chamber body 11, the cover 12, and the first seal ring 13 described above. The cleaning tank 20 and the carrier 80 are disposed inside the chamber body 11, and are also located inside the process space 01 enclosed by the cover 12, the first seal ring 13, and the chamber body 11.

The space above the cleaning tank 20 inside the sealed chamber body 10 may serve as a drying space. The space inside the cleaning tank 20 is a cleaning space. The lifting mechanism 50 is at least partially disposed inside the sealed chamber body 10, and is connected to the carrier 80. The lifting mechanism 50 is configured to drive the carrier 80 to ascend and descend to switch between the drying space and the cleaning space. The sealed chamber body 10 has an overflow space, which is lower than an overflow port of the cleaning tank 20 (the overflow port may be an opening of the cleaning tank 20, or an overflow port slightly lower than the opening of the cleaning tank 20), and the overflow space is located outside the cleaning tank 20.

The lifting mechanism 50 may be entirely located inside the sealed chamber body 10; or, a part of the lifting mechanism 50 may be located inside the sealed chamber body 10 while the remaining part is located outside the sealed chamber body 10, as shown in FIG. 8 to FIG. 12. Considering that a power source for the lifting mechanism 50 is not suitable for being placed in a special environment, in some embodiments, a part of the lifting mechanism 50 may be located inside the sealed chamber body 10, and the remaining part which at least includes the power source may be located outside the sealed chamber body 10. Certainly, in this case, the lifting mechanism 50 needs to be sealed with the sealed chamber body 10, so as to prevent a connection between the lifting mechanism 50 and the sealed chamber body 10 from communicating the process space 01 with the external environment of the process chamber.

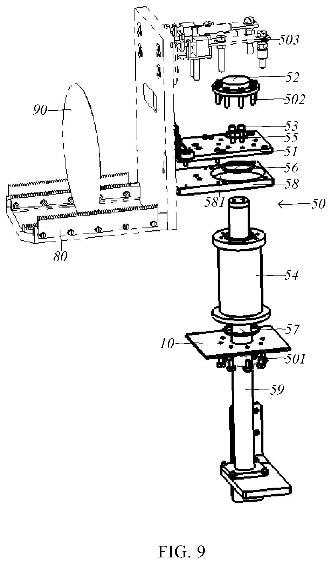

On this basis, referring to FIG. 9 to FIG. 12, in some embodiments, the lifting mechanism 50 may include a first base plate 51, a cap 52, a first connector 53, a lifting rod 59, a telescopic sleeve 54, a third seal ring 55, a fourth seal ring 56, and a fifth seal ring 57.

A first end of the lifting rod 59 is located outside the sealed chamber body 10 for connecting with the power source. The power source may be a hydraulic telescopic member, a pneumatic telescopic member, a linear motor, or the like, and the power source functions to drive the lifting rod 59 to ascend and descend. A second end of the lifting rod 59 extends into the sealed chamber body 10, and is connected to the first base plate 51 with the first connector 53, the cap 52 hermetically covers, by means of the third seal ring 55, a portion of the first connector 53 which is exposed on a first plate surface of the first base plate 51, and the third seal ring 55 achieves hermetic isolation between the process space 01 and an assembly gap between the first connector 53 and the first base plate 51. That is, the first base plate 51 has the first plate surface and a second plate surface opposite to each other, the third seal ring 55 is sleeved over an outer circumferential wall of the lifting rod 59, and the cap 52 hermetically covers the portion of the first connector 53 which is exposed on the first plate surface by means of the third seal ring 55. Illustratively, the first connector 53 may be a screw, a bolt, a rivet, or the like, and a specific type of the first connector 53 is not limited in the embodiments of the present disclosure.

The telescopic sleeve 54 may be located inside the sealed chamber body 10 and sleeved over the lifting rod 59, that is, the lifting rod 59 is inserted into the telescopic sleeve 54. A first end of the telescopic sleeve 54 hermetically abuts against the second plate surface of the first base plate 51 by means of the fourth seal ring 56, that is, the fourth seal ring 56 is also sleeved over the outer peripheral wall of the lifting rod 59, the first end of the telescopic sleeve 54 hermetically abuts against the second plate surface of the first base plate 51 by means of the fourth seal ring 56, and the fourth seal ring 56 seals the first end of the telescopic sleeve 54 with the second plate surface. Thus, hermetic isolation between an inner space (substantially communicating with the external environment of the process chamber) of the telescopic sleeve 54 and the process space 01 can be realized at a position where the first end of the telescopic sleeve 54 is located. A second end of the telescopic sleeve 54 is hermetically connected to the sealed chamber body 10 with the fifth seal ring 57 sleeved over the lifting rod 59. In other words, the fifth seal ring 57 is sleeved over the outer circumferential wall of the lifting rod 59, the second end of the telescopic sleeve 54 is hermetically connected to the sealed chamber body 10 with the fifth seal ring 57, and the first base plate 51 is connected to the carrier 80. The fifth seal ring 57 seals the second end of the telescopic sleeve 54 with the sealed chamber body 10, thereby achieving hermetic isolation between the inner space of the telescopic sleeve 54 and the process space 01 at a position where the second end of the telescopic sleeve 54 is located.

In this case, the telescopic sleeve 54 hermetically abuts against the second plate surface of the first base plate 51 with the fourth seal ring 56, the second end of the telescopic sleeve 54 hermetically abuts against the sealed chamber body 10 with the fifth seal ring 57, the second end of the lifting rod 59 which extends into the sealed chamber body 10 is connected to the first base plate 51 with the first connector 53, and the cap 52 covers the portion of the first connector 53 which is exposed on the first plate surface of the first base plate 51 by means of the third seal ring 55. With such configuration, it is ensured that the lifting rod 59 which is partially located outside the sealed chamber body 10 and partially located inside the sealed chamber body 10 is connected to the carrier 80, and the hermetic isolation between the process space 01 and the external environment of the process chamber can also be ensured.

The second end of the telescopic sleeve 54 may be fixedly connected to the sealed chamber body 10 with a plurality of second connectors 501, and the fifth seal ring 57 may surround the plurality of second connectors 501, so as to prevent the process space 01 from communicating with connection gaps of the plurality of second connectors 501, thereby ensuring sealing. Illustratively, the second connectors 501 may be screws, bolts, rivets, or the like, and a specific type of the second connectors 501 is not limited in the embodiments of the present disclosure.

Illustratively, the cap 52 may be connected to the first base plate 51 with a plurality of third connectors 502 surrounding the third seal ring 55, and the first connector 53 within the cap 52 is hermetically separated from the plurality of third connectors 502 outside the cap 52 by the third seal ring 55. Illustratively, the third connectors 502 may be screws, bolts, rivets, or the like, and a specific type of the third connectors 502 is not limited in the embodiments of the present disclosure.

Further, the plurality of third connectors 502 may penetrate through the first base plate 51 and connected to the first end of the telescopic sleeve 54, and the plurality of third connectors 502 are distributed around the fourth seal ring 56, so that on the premise of ensuring an isolation function of the fourth seal ring 56, the plurality of third connectors 502 can be connected to the first base plate 51, the cap 52, and the first end of the telescopic sleeve 54 at the same time, which achieves the purpose of multiple connections by using a small number of third connectors 502.

Meanwhile, a portion of the lifting rod 59 which is used for sliding fit with the sealed chamber body 10 is kept outside the process space 01, so as to be prevented from generating particles during lifting of the lifting rod 59 to contaminate the process space 01.

Referring to FIG. 9, the lifting mechanism 50 may further include a second base plate 58, which may be parallel to the first base plate 51, and the second base plate 58 is provided with an avoidance hole 581 for avoiding the first end of the telescopic sleeve 54. The lifting mechanism 50 may further include a leveling device 503, which is configured to adjust the carrier 80 to be horizontal, so as to indirectly level the subsequently carried wafer 90.

In the embodiments of the present disclosure, the cleaning tank 20 may be provided with a first on-off valve 21, and the first on-off valve 21 is configured to discharge, in a liquid discharge state, a waste liquid from the cleaning tank 20 to the overflow space which is located inside the sealed chamber body 10 and outside the cleaning tank 20, so as to enable the waste liquid to be finally discharged from the overflow space. With such configuration, a waste liquid generated after a cleaning process in the cleaning tank 20 is completed and a waste liquid overflowing during the cleaning process can both enter the overflow space to be finally discharged from the overflow space. Therefore, there is no need to design respective discharge structures for the overflow space and the cleaning tank 20, which facilitates simplification of the structure of the process chamber.

In a case where the process chamber is the cleaning chamber, the process chamber provided in the embodiment of the present disclosure may further include the drying gas inlet pipe 31 and the water film removal gas inlet pipe 32. The drying gas inlet pipe 31 and the water film removal gas inlet pipe 32 may communicate with the sealed chamber body 10. The drying gas inlet pipe 31 is configured to deliver a drying gas into the drying space, the drying gas may be an inert gas such as nitrogen or argon or other gases capable of being used for drying the wafer 90 without affecting the process, and a specific type of the drying gas is not limited in the embodiments of the present disclosure.

The water film removal gas inlet pipe 32 is configured to deliver a water film removal gas such as isopropanol into the drying space. The water film removal gas has relatively low surface tension and high volatility, so that the water film removal gas may quickly replace a cleaning solution with high surface tension on a surface of the wafer 90 after the wafer 90 is taken out from the cleaning solution, thereby achieving the purpose of quickly removing the cleaning solution, and facilitating implementation a subsequent step of drying the wafer 90 with the drying gas. Certainly, a type of the water film removal gas is not limited in the embodiments of the present disclosure.

Since isopropanol is carcinogenic and highly volatile, isopropanol can be easily mixed with the air in the external environment into an explosive mixture once volatilizing to the external environment of the process chamber, resulting in a significant safety hazard. The process chamber provided in the embodiment of the present disclosure has improved sealing performance, and thus is suitable for a cleaning chamber which adopts isopropanol as a water film removal gas.

As described above, the used cleaning solution overflowing into the overflow space during the cleaning process is the waste liquid, the to-be-discharged cleaning solution remaining in the cleaning tank 20 after the cleaning process is completed is also the waste liquid, and the waste liquid needs to be finally discharged from the process chamber. In view of this, the process chamber provided in the embodiment of the present disclosure may further include a waste liquid discharge pipe 70, which is configured to discharge the waste liquid from the process chamber. The waste liquid discharge pipe 70 may be a single-pipe structure, or may be a structure with at least two pipes, which is not limited in the embodiments of the present disclosure.

In an embodiment, the waste liquid discharge pipe 70 may include a main pipe 71 and at least two branch pipes, and a first end of the main pipe 71 communicates with the overflow space of the sealed chamber body 10. One end of each of the at least two branch pipes is connected in parallel to a second end of the main pipe 71, the at least two branch pipes may be configured to respectively discharge different types of waste liquids, the main pipe 71 is provided with a second on-off valve 75, which is configured to control on and off of the main pipe 71 and also serves as a main switch of the waste liquid discharge pipe 70, each branch pipe is provided with a third on-off valve 76, and all the third on-off valves 76 cooperate in an on-off manner to enable a single branch pipe to independently discharge the waste liquid. With such configuration, when the process chamber adopts different cleaning solutions to perform cleaning processes, waste liquids generated after using the different cleaning solutions can be finally discharged through the respective branch pipes.

Certainly, when the process chamber adopts a same cleaning solution for a cleaning process, the waste liquids generated in different stages may be finally discharged through the corresponding branch pipes. In an embodiment, the at least two branch pipes may include a first branch pipe 72, a second branch pipe 73, and a third branch pipe 74, which may be configured to discharge organic wastewater, general industrial wastewater, and recycled water, respectively. Such configuration can realize classified discharge of the waste liquid, which facilitates saving waste liquid treatment cost of a plant end, and achieves energy saving and efficiency improvement.

Further, each of the at least two branch pipes may be provided with a drain buffer tank 77, and the drain buffer tank 77 performs a buffer function during drainage, thereby avoiding the problem of unstable drainage in the corresponding branch pipe caused by a sudden change in flow, and also preventing the discharged waste liquid from returning to the process space 01.

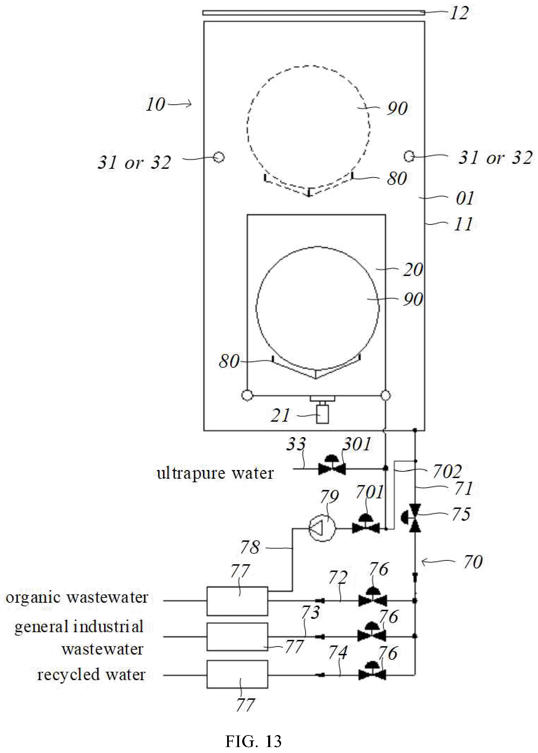

Referring to FIG. 13, the process chamber provided in the embodiment of the present disclosure may further include a negative pressure suction pipe 78, which is provided with a negative pressure pump 79 and a fourth on-off valve 701. In an embodiment, a first end of the negative pressure suction pipe 78 may communicate with the overflow space. Alternatively, in another embodiment, the first end of the negative pressure suction pipe 78 may extend into the sealed chamber body 10 and communicate with the cleaning tank 20. The negative pressure suction pipe 78 is configured to perform negative pressure suction on the process space 01, so as to completely pump out a toxic gas from the process space 01 after the cleaning process is completed, thereby avoiding a safety problem caused by overflowing of the residual toxic gas when the cover 12 is opened to take out the wafer 90.

The process chamber provided in the embodiment of the present disclosure may further include: the cleaning solution inlet pipe 33, which is configured to introduce the cleaning solution into the cleaning tank 20. In an embodiment, the cleaning solution inlet pipe 33 may communicate with a bottom of the cleaning tank 20, so as to introduce the cleaning solution through the bottom of the cleaning tank 20 for gradually filling the cleaning tank 20 with the cleaning solution and enabling subsequent overflowing. This way of introducing the cleaning solution from bottom to top can enable particles washed off the wafer 90 during the cleaning process to be easily discharged out of the cleaning tank 20 by overflowing.

In an embodiment, one end of the cleaning solution inlet pipe 33 may be connected between two ends of the negative pressure suction pipe 78, and the cleaning solution inlet pipe 33 may be provided with a fifth on-off valve 301, and the fifth on-off valve 301 is configured to control on and off of the cleaning solution inlet pipe 33, thereby controlling supply of the cleaning solution. In this case, the cleaning solution inlet pipe 33 may communicate with the cleaning tank 20 through a section (i.e., a part of a pipe section) of the negative pressure suction pipe 78 to introduce the cleaning solution into the cleaning tank 20. In an exemplary operation process, the fourth on-off valve 701 may be closed, the fifth on-off valve 301 may be opened, and the cleaning solution in the cleaning solution inlet pipe 33 may enter the cleaning tank 20 through the section of the negative pressure suction pipe 78. Certainly, after the cleaning process is completed, the waste liquid in the cleaning tank 20 is discharged to the overflow space through the first on-off valve 21, then the fifth on-off valve 301 may be closed, and the fourth on-off valve 701 may be opened after drainage of the waste liquid, so that the negative pressure suction pipe 78 may communicate with the emptied cleaning tank 20 to perform negative pressure suction on the entire process space 01.

Such configuration can realize sharing of the partial pipe section by the cleaning solution inlet pipe 33 and the negative pressure suction pipe 78, thereby simplifying the structure of the process chamber.

Referring to FIG. 13, further, the process chamber provided in the embodiment of the present disclosure may further include an adapter tube 702. A first end of the adapter tube 702 may be connected between the two ends of the negative pressure suction pipe 78 and located on a side of the fourth on-off valve 701 away from the negative pressure pump 79. A second end of the adapter tube 702 may directly communicate with the overflow space, or may be connected to the main pipe 71 to communicate with the overflow space via the main pipe 71. In this case, during negative pressure suction by the negative pressure pump 79, the negative pressure pump 79 may also perform negative pressure suction on the overflow space via the adapter tube 702, so that the negative pressure pump 79 can perform negative pressure suction not only via the pipe section shared with the cleaning solution inlet pipe 33 but also via the adapter tube 702, which can improve negative pressure suction efficiency.

Certainly, in a case where the second end of the adapter tube 702 is connected to the main pipe 71 to communicate with the overflow space via the main pipe 71, the adapter tube 702 uses part of a pipe section of the main pipe 71 to communicate with the overflow space, so that there is no need to design the adapter tube 702 to be too long, which facilitates saving consumables of the adapter tube 702, and can simplify pipeline structures of the process chamber.

It should be noted that in the embodiments of the present disclosure, the process chamber may be the cleaning chamber. The cleaning solution related to the cleaning chamber may be water (e.g., ultrapure water), an acidic chemical solution, or other types of cleaning solutions applicable to the field of semiconductor cleaning. A specific type of the cleaning solution is not limited in the embodiments of the present disclosure
Referring to FIG. 13, a cleaning process in a case where the process chamber is the cleaning chamber is described in detail below by taking a case where the drying gas is nitrogen, the water film removal gas is isopropanol, and the cleaning solution is ultrapure water as an example. The cover 12 is moved into the closed state before the cleaning process is performed, so that the cover 12 seals the opening 02 of the chamber body 11. After the cover 12 is in the closed state, the drying gas inlet pipe 31 injects nitrogen in the process space 01, and the lifting mechanism 50 drives the carrier 80 to ascend to the drying space to prepare to receive the wafer 90, during which the drying gas inlet pipe 31 keeps injecting nitrogen. The fifth on-off valve 301 is opened, so that ultrapure water is introduced into the cleaning tank 20 through the cleaning solution inlet pipe 33 (at this time, the fourth on-off valve 701 is closed). With continuous supply of the ultrapure water, the cleaning tank 20 is gradually filled with the ultrapure water and starts to enter a slight-overflow state, at this time, the second on-off valve 75 and the third on-off valve 76 on the third branch pipe 74 are opened to recover the ultrapure water (at this time, since the ultrapure water is not used to clean the wafer 90, the ultrapure water is recyclable). Then, the cover 12 is opened; since the drying gas supply pipe 31 keeps injecting nitrogen before and after the cover 12 is opened, nitrogen occupies the inner space of the chamber body 11 to ensure that no gas in the external environment of the process chamber can intrude into the chamber body 11. Then, the carrier 80 descends after receiving the wafer 90, the wafer 90 is lowered into the ultrapure water in the cleaning tank 20 along with the carrier 80, and the cover 12 is closed.

Then, a water inflow rate of the cleaning solution inlet pipe 33 is adjusted to a preset flow rate (greater than a water inflow rate in the slight-overflow state) for continuous rinsing of the wafer 90, and the drying gas inlet pipe 31 is adjusted to supply nitrogen at a preset flow rate. After the rinsing lasts for a first preset time period, the water film removal gas inlet pipe 32 is opened and injects isopropanol in the process space 01, at this time, the fifth on-off valve 301 may be closed. In this case, the drying gas inlet pipe 31 and the water film removal gas inlet pipe 32 introduces nitrogen and isopropanol into the process space 01, respectively. During the cleaning process, the third on-off valve 76 on the first branch pipe 72 is opened, and the third on-off valve 76 on the third branch pipe 74 is closed, and the waste liquid overflowing into the overflow space is discharged from the overflow space through the first branch pipe 72; and the waste liquid generated in this stage may be organic wastewater. After the injection lasts for a second preset time period, the lifting mechanism 50 is controlled to lift the carrier 80 to move the wafer 90 out of the cleaning tank 20.

The drying gas inlet pipe 31 and the water film removal gas inlet pipe 32 keep injecting nitrogen and isopropanol; meanwhile, the lifting mechanism 50 lifts the wafer 90 to a preset position, during which isopropanol may quickly remove a water film from the wafer 90 to prepare for subsequent drying by the drying gas. When the lifting mechanism 50 drives the wafer 90 to the preset position, the drying gas inlet pipe 31 injects nitrogen to dry the wafer, and the water film removal gas inlet pipe 32 stops injecting isopropanol. At this time, the first on-off valve 21 is opened to enable the waste liquid to be discharged from the cleaning tank 20 to the overflow space, then the waste liquid is discharged from the overflow space through the first branch pipe 72, and the second on-off valve 75 is closed after the drainage of the waste liquid.

Then, the drying gas inlet pipe 31 stops the supply of nitrogen, and the negative pressure pump 79 is turned on and the fourth on-off valve 701 is opened for pumping (at this time, the fifth on-off valve 301 is closed, so that the cleaning solution inlet pipe 33 stops introducing the cleaning solution into the cleaning tank 20). When a pressure in the process space 01 reaches a preset value, the negative pressure pump 79 is turned off, the fourth on-off valve 701 is closed, and the residual isopropanol in the process space 01 is completely discharged. Then, the drying gas inlet pipe 31 is opened again to introduce nitrogen into the process space 01 to keep a gas pressure in the process space 01 consistent with the atmospheric pressure in the external environment of the process chamber, so as to facilitate opening of the cover 12. Then, the cover 12 is opened, and the wafer 90 is taken away by a transfer device (e.g., a manipulator). Finally, the cover 12 is closed.

Certainly, in a case where the cleaning solution is an acidic cleaning solution, the waste liquid overflowing during the cleaning process may be discharged as industrial wastewater through the second branch pipe 73.

As can be seen from the above description of the cleaning process, during the cleaning process, the drying gas injected by the drying gas inlet pipe 31 not only serves to avoid gas intrusion from the external environment of the process chamber, but also performs a drying function; meanwhile, the drying gas injected by the drying gas inlet pipe 31 further serves to adjust the pressure in the process space 01. Through the timely gas supply to the process space 01 after the negative pressure suction is completed, the pressure in the process space 01 is prevented from being too low, which can avoid the problem that the cover 12 is difficult to open due to a too low pressure in the process space 01.

Based on the process chamber provided in the embodiment of the present disclosure, an embodiment of the present disclosure further provides a semiconductor process apparatus, including the process chamber described in the above embodiments.

The above embodiments of the present disclosure focus on the differences between the embodiments, and different technical features of the embodiments can be combined to form more specific embodiments as long as the different features are not contradictory, which will not be described in detail here for conciseness of the description.

The embodiments of the present disclosure are described above with reference to the drawings, but the present disclosure is not limited to the above specific implementations which are just for illustration rather than for limitation. Enlightened by the present disclosure, those of ordinary skill in the art can make many variations in forms without departing from the spirit of the present disclosure and the scope of the claims, and all those variations should be considered to fall within the scope of the present disclosure.

## Claims

1. A cover device, comprising a cover, a connection base, and a cover base, wherein a first end of the cover base is rotatably connected to the connection base, the cover base has a first state and a second state, and a second end of the cover base is rotatable around the first end of the cover base to switch the cover base between the first state and the second state;
in the first state of the cover base, the cover is tilted relative to a preset plane, and the cover is movable relative to the cover base; and
in the second state of the cover base, the cover is parallel to the preset plane.

2. The cover device of claim 1, further comprising:
a first drive mechanism, which is disposed on the cover base and connected to the cover, and is configured to drive the cover to move when the cover base is in the first state.

3. The cover device of claim 1, wherein
the cover base is provided with a guide part, and the cover is in guiding engagement with the guide part to be guided to move when the cover base is in the first state.

4. The cover device of claim 3, wherein
at least two guide parts are provided and spaced apart on the cover base.

5. The cover device of claim 1, further comprising:
a second drive mechanism, which is connected to the cover base, and is configured to drive the second end of the cover base to rotate around the first end of the cover base to switch the cover base between the first state and the second state.

6. The cover device of claim 1, wherein
the cover has a first preset position relative to the cover base, and when the cover is moved to the first preset position, the cover is far away from the first end of the cover base; and the cover base is provided with a first limiting buffer portion, which is used for limit fit with the cover moved to the first preset position; and/or,
the cover has a second preset position relative to the cover base, and when the cover is moved to the second preset position, the cover is close to the first end of the cover base; and the cover base is provided with a second limiting buffer portion, which is used for limit fit with the cover moved to the second preset position.

7. The cover device of claim 1, wherein
the cover has a first preset position relative to the cover base, and when the cover is moved to the first preset position, the cover is far away from the first end of the cover base;
the cover base is provided with a closure detection sensor, the cover is provided with a closure detection trigger, and the closure detection trigger is configured to trigger the closure detection sensor when the cover is moved to the first preset position; and/or,
the cover has a second preset position relative to the cover base, and when the cover is moved to the second preset position, the cover is close to the first end of the cover base; and
the cover base is provided with an opening detection sensor, the cover is provided with an opening detection trigger, and the opening detection trigger is configured to trigger the opening detection sensor when the cover is moved to the second preset position.

8. A process chamber, comprising a first seal ring, a chamber body, and the cover device of any one of claims 1 to 7, wherein the chamber body is provided with an opening, the first seal ring is configured to seal the opening, the first end of the cover base is far away from the opening, the second end of the cover base is close to the opening, and the preset plane is parallel to a plane where the opening is located;
in the first state of the cover base, the cover is tilted relative to the plane where the opening is located, and the cover is movable between a position for avoiding the opening and a position opposite to the opening; and
when the cover is located at the position opposite to the opening, the cover base is configured to be rotatable, while carrying the cover, to the second state in which the cover is parallel to the plane where the opening is located, so as to cause the cover to compress the first seal ring.

9. The process chamber of claim 8, further comprising:
a pressing mechanism, which is connected to an outer wall of the chamber body, and is configured to apply a pressure to the cover for the cover to compress the first seal ring when the cover is located at a position at which the cover is opposite to the opening and parallel to the plane where the opening is located.

10. The process chamber of claim 9, wherein
at least two pressing mechanisms are provided and are spaced apart on the outer wall of the chamber body.

11. The process chamber of claim 9, wherein
the pressing mechanism comprises: a third drive mechanism and a pressing member, the third drive mechanism is connected to the chamber body, the pressing member is in driving engagement with the third drive mechanism, and the third drive mechanism is configured to drive the pressing member to switch between a releasing state and a pressing state,
in the pressing state, a partial structure of the pressing member abuts against a side of the cover away from the chamber body, and presses the cover towards the chamber body to enable the cover to compress the first seal ring; and
in the releasing state, the pressing member is separated from at least the cover.

12. The process chamber of claim 11, wherein
the cover is movable relative to the chamber body, and when the cover is moved to a position for covering the opening, an edge of the cover is located between the chamber body and the partial structure of the pressing member which is configured to abut against the cover.

13. The process chamber of claim 12, wherein
the pressing member is an L-shaped structural member, and comprises a first right-angle side and a second right-angle side perpendicularly connected to each other, the first right-angle side is in driving connection with the third drive mechanism, and when the cover is moved to the position for covering the opening, the edge of the cover is located between the second right-angle side and the chamber body.

14. The process chamber of claim 11, wherein
the pressing mechanism further comprises: a fourth drive mechanism, which is connected to an extendable end of the third drive mechanism, the pressing member is connected to an extendable end of the fourth drive mechanism, and the third drive mechanism is configured to drive the pressing member through the fourth drive mechanism to switch between the pressing state and the releasing state; and the fourth drive mechanism is configured to drive the pressing member to switch between a first position and a second position,
at the first position of the pressing member, the pressing member is located on the side of the cover away from the chamber body; and
at the second position of the pressing member, the pressing member is staggered relative to the cover, and a moving direction of the third drive mechanism for driving the pressing member is different from a moving direction of the fourth drive mechanism for driving the pressing member.

15. The process chamber of claim 14, wherein
the pressing member is a flat structural member.

16. The process chamber of claim 8, further comprising:
a pipeline, a sealing plate, a second seal ring, and a sealing joint, wherein the chamber body is provided with a mounting hole, the sealing plate is detachably fixed to the mounting hole in the chamber body, the mounting hole is sealed with the second seal ring, the sealing plate is provided with a communicating hole, and the pipeline is detachably connected to the communicating hole with the sealing joint to communicate with the chamber body.

17. The process chamber of claim 16, wherein
a plurality of pipelines are provided, the sealing plate is provided with at least two communicating holes in one-to-one correspondence with the pipelines, and the plurality of pipelines are respectively hermetically connected to the corresponding communicating holes through corresponding sealing joints.

18. The process chamber of claim 16, wherein
the sealing joint hermetically communicates with the corresponding communicating hole by means of sealed threaded fit.

19. The process chamber of any one of claims 8 to 18, comprising a sealed chamber body, which comprises the chamber body, the cover, and the first seal ring, wherein the process chamber further comprises a cleaning tank, a lifting mechanism, and a carrier for carrying a wafer, wherein
the cleaning tank and the carrier are disposed inside the sealed chamber body, the space above the cleaning tank inside the sealed chamber body serves as a drying space, the space inside the cleaning tank is a cleaning space, the lifting mechanism is at least partially disposed inside the sealed chamber body and is connected to the carrier, the lifting mechanism is configured to drive the carrier to ascend and descend to switch between the drying space and the cleaning space, the sealed chamber body has an overflow space, and the overflow space is lower than an overflow port of the cleaning tank, and is located outside the cleaning tank.

20. The process chamber of claim 19, wherein the lifting mechanism comprises: a first base plate, a cap, a first connector, a lifting rod, and a telescopic sleeve, wherein,
the first base plate has a first plate surface and a second plate surface opposite to each other,
a first end of the lifting rod is located outside the sealed chamber body, a second end of the lifting rod extends into the sealed chamber body, and is connected to the first base plate with the first connector, and the cap hermetically covers a portion of the first connector which is exposed on the first plate surface;
the telescopic sleeve is located inside the sealed chamber body and sleeved over the lifting rod, and a first end of the telescopic sleeve hermetically abuts against the second plate surface, and
a second end of the telescopic sleeve is hermetically connected to the sealed chamber body, and the first base plate is connected to the carrier.

21. The process chamber of claim 19, wherein
the cleaning tank is provided with a first on-off valve, which is configured to discharge a waste liquid from the cleaning tank to the overflow space in a liquid discharge state.

22. The process chamber of claim 19, further comprising:
a drying gas inlet pipe and a water film removal gas inlet pipe, which communicate with the sealed chamber body, wherein the drying gas inlet pipe is configured to deliver a drying gas to the drying space, and the water film removal gas inlet pipe is configured to deliver a water film removal gas to the drying space.

23. The process chamber of claim 19, further comprising:
a waste liquid discharge pipe, which comprises: a main pipe and at least two branch pipes, wherein a first end of the main pipe communicates with the overflow space of the sealed chamber body, one end of each of the at least two branch pipes is connected in parallel to a second end of the main pipe, the at least two branch pipes are configured to respectively discharge different types of waste liquids, the main pipe is provided with a second on-off valve, and each branch pipe is provided with a third on-off valve.

24. The process chamber of claim 23, wherein
the at least two branch pipes comprise: a first branch pipe, a second branch pipe, and a third branch pipe, which are configured to discharge organic wastewater, industrial wastewater, and recycled water, respectively.

25. The process chamber of claim 24, wherein
each of the at least two branch pipes is provided with a drain buffer tank.

26. The process chamber of claim 23, further comprising:
a negative pressure suction pipe, which is provided with a negative pressure pump and a fourth on-off valve, wherein a first end of the negative pressure suction pipe communicates with the overflow space, or extends into the sealed chamber body and communicates with the cleaning tank, and a second end of the negative pressure suction pipe communicates with at least one of the at least two branch pipes.

27. The process chamber of claim 26, further comprising:
a cleaning solution inlet pipe, wherein one end of the cleaning solution inlet pipe is connected between two ends of the negative pressure suction pipe, and the cleaning solution inlet pipe is provided with a fifth on-off valve.

28. The process chamber of claim 26, further comprising:
an adapter tube, wherein a first end of the adapter tube is connected between two ends of the negative pressure suction pipe and located on a side of the fourth on-off valve away from the negative pressure pump, and a second end of the adapter tube is connected to the main pipe and communicates with the overflow space via the main pipe.

29. A semiconductor process apparatus, comprising the process chamber of any one of claims 8 to 28.
